# EUROPEAN PATENT APPLICATION

(11) **EP 2 501 037 A1**
(43) Date of publication of application: **19.09.2012**
(21) Application number: 11305275.7
(22) Date of filing: 14.03.2011
(51) Int. Cl.: H03F 3/217, H03F 3/189, H03F 1/56

(54) **Output signal termination concept for switch-mode power amplifier**

(71) Applicant: Alcatel Lucent, 75007 Paris (FR)
(72) Inventor: Wiegner, Dirk, 71409 Schwaikeim (DE); Maier, Simone, 70565 Stuttgart (DE)
(74) Representative: 2SPL Patentanwälte

(57) **Abstract**

Embodiments relate to a concept for amplifying an input signal (112) having a varying signal envelope corresponding to an input signal frequency spectrum, the concept comprising generating (410) a pulse-width modulated signal (115) based on a periodic oscillator signal (113) and the received input signal (112), amplifying (420) the generated pulse-width modulated signal (115) with a switch-mode amplifier circuit (120) to obtain an amplified pulse-width modulated signal (125) at an output of the switch-mode amplifier circuit (120), terminating (430), in the amplified pulse-width modulated signal (125), at least one undesired spectral component (220; 230; 240) originating from the periodic oscillator signal (113) to obtain a terminated signal (325), and reconstructing (440) an amplified version of the input signal (112) based on the terminated signal (325).

## Description

The present invention relates to amplification of electronic signals, more particularly but not exclusively to amplification of radio signals in mobile or base station transceivers of wireless communication systems.

### Background

Wireless networks are steadily growing and more and more systems for mobile communication are deployed. For example, multiple generations of cellular systems have been developed and introduced to the mass markets. With the continuous extension and improvement of these communication systems their inherent power consumption becomes more and more an issue. One of the major contributors to the power consumption of wireless communication systems are the base station transceivers, which are deployed to provide an almost 100% service coverage. The power consumption of a base station transceiver depends on several factors, where one major factor is the power consumption of the power amplifiers used for transmission of the RF signals (RF as abbreviation for radio frequency). Power amplifiers are one the most power consuming parts within a radio base station transceiver.

Therefore the efficiency of the power amplifier is critical to the overall power consumption of a base station transceiver and further to the power consumption of an entire network. Efficiency is a measure of how much of a source or supply power is usefully applied to the amplifier's output or load, i.e. radiated as RF power. In RF power amplifiers used in cellular base stations and broadcast transmitters special design techniques are used to improve efficiency. Doherty designs, which use a second transistor, can improve efficiency from the typical 30% up to 45% in a narrow bandwidth. Envelope tracking designs are able to achieve efficiencies of up to 50%, by modulating the supply voltage to the amplifier in line with the envelope of the signal.

Such designs will certainly continue to evolve in coming years, but to increase efficiency significantly also other amplifier technologies have to be considered. In order to achieve this in the mid-term, switch-mode (also called switched-mode) amplifiers are being discussed intensively at present, as they may theoretically reach up to 100% efficiency, i.e., all of the power supplied to it may be delivered to the load, none is turned to heat. This is because an ideal switch in its on state will conduct all current but has no voltage across it, hence no heat is dissipated. And when it is off, it will have the full supply voltage standing across it, but no current flows through it. Again, no heat is dissipated. Real GaN-HEMTs (Gallium Nitride High Electron-Mobility Transistors) are not ideal switches, but practical efficiencies over 90% are realistic.

One alternative of a switch-mode amplifier is the so-called Class-D or Class-S power amplifier concept, wherein the terminology is not uniform on a worldwide basis. Depending on the respective author involved, the amplifier types are referred to either as Class-D or Class-S. Hereinafter in the description of embodiments, the term "Class-S" amplifier will be used for such switch amplifiers, in which a e.g. a 1-bit modulator such as a Sigma-Delta Modulator, a Pulse Density Modulator (PDM) or a Pulse-Width Modulator (PWM) is combined with a high-efficiency power switch and an output reconstruction filter. The 1-bit modulator transforms an electrical digital or analogue input signal (having a varying envelope) into square waves allowing the Class-D amplifier stage, comprising two power transistors, to be driven as a switch. A passive band-pass reconstruction filter downstream to the Class-D amplifier stage removes unwanted out-band frequency components, i.e., smooths the pulses out and recovers the desired (amplified) RF band-pass frequency signal.

First Class-S power amplifier demonstrators for amplifying RF signals are presently available, which, however, do currently not yet show the required linearity and efficiency needed for wireless communication systems. A recent result of a Class-S amplifier using a Pulse-Width-Modulator showed promising linearity, also meeting 3GPP (3^{rd} Generation Partnership Project) requirements, but unfortunately its efficiency is still behind expectations. Efficiency of Class-S amplifiers is affected e.g. by the applied square wave modulation scheme, by the switch-mode amplifier stage as well as by a downstream-connected signal reconstruction filter. The latter one has to meet hard noise signal termination requirements (in-band as well as out-band) in order to enable high energy efficiency.

Depending on the type of Class-S amplifier control (voltage- or current-controlled), different solutions for reconstruction filters, such as single-ended or differential combline-filter, with or without pre-distortion network, are known in order to meet the termination requirements. However, known solutions for reconstruction filters are mainly related to Bandpass-Delta-Sigma-Modulation (BPDSM) schemes, where quantization noise is shaped to lie out-band and, hence, the reconstruction filters have to meet the hard out-band signal termination requirements in a very wideband manner in order to keep high amplifier efficiencies. This seems to be a very difficult task and has not yet resulted in a fully satisfying solution up to now. Additionally, BPDSM shows a relatively low bandwidth of the noise-notch, resulting in limited overall supported Class-S amplifier bandwidth.

Hence, it is desirable to provide an improved Class-S power amplifier concept, in particular applicable for mobile communication systems applying radio frequencies in the range of several hundred MHz to several GHz.

### Summary

Embodiments may be based on the finding that, with respect to switch-mode power amplifier concepts for RF signals, the PWM modulation scheme only introduces a relatively small amount of additional noise to a PWM modulated RF input signal compared to the commonly preferred sigma-delta modulation scheme, which introduces additional quantization noise to the sigma-delta modulated signal to be amplified. This quantization noise may be shaped to lie out-band, but as a consequence downstream-located reconstruction filters have to meet very hard out-band signal termination requirements in a very wideband manner in order to keep high amplifier efficiencies.

Embodiments may be further based on the finding that for band-pass RF signals having center frequencies in the range of a few hundred MHz (e.g. 500 MHz) to a few GHz (e.g. 5 GHz), a frequency of an oscillator signal needed for PWM may not easily be chosen to lie way above the frequency band of the RF signal to be amplified by the Class-D power amplifier. For RF applications in present wireless communication systems, the frequency of a local oscillator signal of a PWM for modulating a RF input signal will typically lie in the order of magnitude of the center frequency of the RF input signal to be amplified. Alternatively, also fully digital or mixed-signal modulator concepts are possible, which may receive a digital baseband signal as input signal and may output a 1-bit PWM modulated digital RF signal. Such modulator concepts, hence, may also include frequency up-conversion.

Embodiments may be further based on the finding that when using a PWM modulation scheme for a switch-mode power amplification scheme for RF signals used in wireless communications, there will be undesirable or unwanted signal components in the amplified PWM signal due to the periodic local oscillator signal used for pulse-width modulating the RF input signal. Such unwanted signal components may be signal components at the oscillator frequency as well as frequency components due to mixing products of the RF center frequency and the local oscillator frequency. Depending on the local oscillator signal frequency and/or the RF input signal center frequency, these unwanted signal components may even be located in or close to the transmission band (in-band) of the RF band-pass signal to be amplified by the switch-mode power amplifier. However, it is desirable to position the unwanted signal components out of the transmission band.

Embodiments may particularly be based on the finding that an improved and more efficient switch-mode power amplifier concept for amplifying RF signals may be obtained when terminating such undesirable signal components downstream to an output of the switch-mode amplifier stage. I.e., it is one finding that a correctly designed termination circuit connected downstream to the amplifier output may ensure that the switch-mode amplifier stage does essentially not dissipate or use transmit power at the (discrete) undesired signal components originating from the PWM local oscillator signal.

This may lead to a highly-efficiently amplified RF band-pass signal with none or only little impairment and, hence, at the same time, to relaxed requirements for a downstream-connected signal reconstruction filter compared to conventional previously known switch-mode power amplifiers.

Embodiments provide an amplifier circuit comprising an input for receiving an input signal having a varying signal envelope corresponding to a frequency spectrum around an input signal center frequency. The amplifier circuit further comprises a pulse-width modulation (PWM) circuit, which is coupled to the input and which is adapted to generate a pulse-width modulated signal based on a periodic oscillator signal and based on the received input signal. Downstream to the PWM circuit, a switch-mode amplifier stage is adapted to amplify the generated PWM signal to obtain an amplified PWM signal at an output of the switch-mode amplifier stage. A termination circuit is coupled to the output of the switch-mode amplifier stage, wherein the termination circuit is adapted to terminate, in the amplified PWM signal, at least one undesired signal component originating from the periodic oscillator signal to obtain a terminated PWM output signal. The terminated PWM output signal may then be coupled to a signal reconstruction filter for reconstructing an amplified version of the input signal based on the terminated PWM output signal.

The input signal may generally be any electrical signal. In particular, the input signal however may be a digital or analogue baseband (BB) or RF signal. I.e., the amplifier circuit may be adapted to amplify RF signals having center frequencies in a frequency range from e.g. 0 MHz to 5 GHz. A useful frequency spectrum, i.e. a transmission band (in-band), of the radio frequency input signal may e.g. vary in a range from several kHz up to several MHz, corresponding to RF signals used in present 2G to 4G digital mobile communication systems. Transmission bandwidths of WCDMA (Wideband Code Division Multiple Access) or OFDM (Orthogonal Frequency-Division Multiplexing) signals may typically be in a range from about 1.25 MHz to 20 MHz. Carrier frequencies of present mobile communication systems are typically in the range of e.g. 900 MHz (GSM/EDGE) to 2.7 GHz (WCDMA or LTE).

The PWM circuit may hence be adapted to modulate digital or analog RF input signals in a frequency range from baseband (BB) to 5 GHz. I.e., a local oscillator of the PWM has to be adapted to provide a periodic oscillator signal with an oscillator frequency suitable for modulating such BB or RF input signals. Such an oscillator frequency may be chosen to be in the order of magnitude of the center frequency of the BB or RF input signal. In some embodiments the PWM oscillator frequency may also be chosen to be larger (smaller) than the largest (smallest) frequency component of the transmission band.

The switch-mode amplifier stage may comprise a voltage-mode or current-mode Class-D amplifier (switching amplifier) comprising a topology with two switches for amplifying positive and negative pulses, respectively. The switches may be realized by transistors, such as e.g. high-electron-mobility-transistors (HEMTs) or field-effect transistors (FETs).

The signal reconstruction filter may be an analogue band-pass filter having a pass-band essentially corresponding to the transmission band of the RF input signal, i.e. the modulating signal. I.e., the pass-band may essentially correspond to the input signal frequency spectrum around the input signal center frequency or to the input signal frequency spectrum around a center frequency of an amplified version of the input signal, i.e. an amplified RF output signal.

According to embodiments the termination circuit may be adapted to terminate an undesired signal component at the oscillator frequency of the PWM oscillator signal in desired loads, such as e.g. antenna devices. Due to the pulse-with modulation of the RF input signal the resulting PWM-signal also has undesired spectral signal components e.g. at frequencies corresponding to the PWM local oscillator frequency and/or corresponding to mixing products of the center frequency and the local oscillator frequency. Hence, the termination circuit may be further adapted to terminate an undesired signal component also e.g. at a frequency corresponding to a mixing product of the oscillator frequency and the input signal frequency.

For the undesired signal termination, the termination circuit is adapted to provide a short circuit to the undesired signal components at the output of the switch-mode amplifier-stage. In other words, at least some of the undesired signal components may be shorted at the amplifier output (towards ground). This may be achieved by impedance matching techniques to terminate the unwanted frequencies in desired loads. Hence, the termination circuit is adapted or configured such that no or reduced transmit power is consumed or dissipated (i.e. wasted) by the switch-mode amplifier-stage at the undesired frequency components. This may enable a more efficient switch-mode or Class-S amplifier concept, in particular for RF signals, compared to existing solutions.

The termination circuit coupled to the output of the switch-mode amplifier-stage may comprise at least one resonator circuit which is adapted to provide a short-circuit termination for the at least one undesired signal component of the amplified PWM signal. I.e., the at least one resonator circuit can be tuned to a frequency of the at least one undesired signal component of the amplified PWM signal in order to provide a short-circuit for said unwanted frequency. Depending on the RF frequency range in question, the at least one resonator circuit may be formed by discrete passive reactive components, such as inductors and/or capacitors. In particular for high carrier frequencies of the RF input signal, the at least one resonator circuit may also comprise signal transmission lines for exploiting their inductive and capacitive and, hence, resonance properties.

According to some embodiments the termination circuit may be located between the output of the switch-mode amplifier-stage and an input of the downstream-connected RF signal reconstruction filter. It may be coupled between the output of the amplifier-stage and ground (shunt) and/or between the output and the input of the reconstruction filter (series). However, the termination circuit may as well be integrated in the signal reconstruction filter. In further embodiments the termination circuit may also be integrated on a common multi-layer printed circuit board (PCB) together with the reconstruction filter. Hence, the termination circuit does not necessarily have to be a dedicated circuit separated from other filter or electrical circuits of the amplifier circuit. In some embodiments the termination circuit may also be integrated on a same Monolithic Microwave Integrated Circuit (MMIC) as the switch-mode amplifier-stage.

In some embodiments more flexibility could be obtained by employing switchable or tunable terminations (e. g. a tunable capacity) for different undesired frequencies. Hence, the termination circuit may also be adapted to vary (switch and/or tune) between different terminations corresponding to different undesired signal components, for example, originating from different periodic oscillator signals having different oscillator frequencies, respectively. Such embodiments could, for example, be used when the amplifier circuit shall be used for amplifying different RF signals having different transmission or center frequencies. Alternatively or additionally different PWM local oscillator signals may be used, leading to different unwanted signal components.

Embodiments also comprise transceivers for a wireless communication system, such as a mobile station/terminal transceiver or a base station transceiver, employing at least one amplifier circuit according to embodiments of the present invention.

Moreover, embodiments also provide a method for amplifying an input signal having a varying signal envelope corresponding to an input signal frequency spectrum, the method comprising generating a pulse-width modulated signal based on a periodic oscillator signal and the received input signal. The method further comprises amplifying the generated pulse-width modulated signal with a Class-D switch-mode amplifier circuit to obtain an amplified pulse-width modulated signal at an output of the switch-mode amplifier circuit. In the amplified pulse-width modulated signal at least one undesired spectral component originating from the periodic oscillator signal is terminated to obtain a terminated PWM signal. Then, an amplified version of the input signal is reconstructed based on the terminated PWM signal.

Globally, Class-S is a promising amplifier concept for future highly efficient mobile radio amplifiers supporting a wide signal bandwidth. Currently, the Class-S concept is under research and parameters like efficiency and linearity have to be improved in order to make the concept applicable to mobile radio applications and to meet the overall performance expectations. An advantage of embodiments is to improve efficiency and reduce effort on the reconstruction filter. Thus, the presented solution may lead to an efficiency improved Class-S amplifier with higher output power.

### Brief description of the Figures

Some embodiments of apparatuses and/or methods will be described in the following by way of example only, and with reference to the accompanying figures, in which
- Fig. 1: shows a conventional basic Class-S amplifier concept using PWM;
- Fig. 2: shows an exemplary spectral overview of desired and/or undesired spectral signal components resulting from the conventional Class-S amplifier concept according to Fig. 1;
- Fig. 3: shows an a schematic block diagram of an embodiment of an Class-S switch-mode amplifier circuit; and
- Fig. 4: shows an embodiment of a method for amplifying an RF signal with a Class-S switch-mode amplifier.

### Description of Embodiments

This disclosure is generally directed to a concept for amplifying an electrical signal. More particularly, the concepts and/or techniques involve implementation of an amplifier circuit comprising a switched mode Class-D amplifier stage for amplifying RF signals. The disclosed amplifier circuit may be implemented in a variety of communication devices or systems. For example, such an amplifier circuit may be implemented in mobile phones, base stations etc. Although the following systems and methods are described with reference to a wireless communication system, it will be appreciated by a skilled person that the disclosed amplifier concept may be as well be generally implemented in any electronic communication system, also including, for example, audio systems.

Throughout the following description, specific details are set forth in order to provide a more thorough understanding of embodiments. However, embodiments may also be practiced without such particulars. In other instances, well-known elements are not shown or described in detail to avoid unnecessarily obscuring embodiments of the invention. Accordingly, the specification and drawings are to be regarded in an illustrative rather than a restrictive sense.

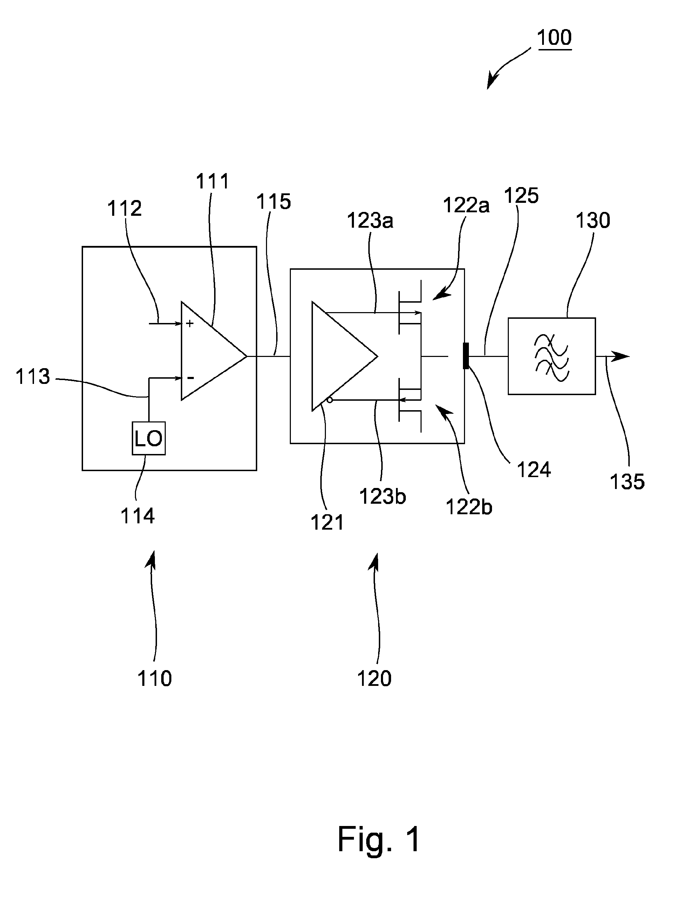

An illustrative description of the embodiments will be given in details combined with the appended figures. For the ease of understanding, some conventional technical terms are explained first. For this purpose Fig. 1 shows a schematic block diagram of a conventional Class-S amplifier 100. The amplifier 100 comprises a square wave modulator stage 110, a switching amplifier stage 120 and a signal reconstruction filter stage 130.

The square wave modulator stage 110 may comprise a PWM modulator 111 for modulating an (analog or digital) baseband or RF input signal 112 using a periodic oscillator signal 113, which may be generated by a PWM local oscillator device 114. The BB or RF input signal 112 may be centered around a center or transmission frequency f_{c} (sometimes also referred to as fundamental frequency), and may e.g. be a WCDMA, OFDM, etc., or a common harmonic sinusoidal signal. One possible way of creating a PWM output signal 115 is to use a high-speed comparator 111, which is adapted to compare the periodic PWM oscillator signal 113 with the input signal 112. For example, the periodic PWM oscillator signal 113 may be a sawtooth or triangular wave signal. The comparator 111 may compare two voltages or currents of its input signals 112, 113 and switch its output to indicate which one is larger. Hence, the comparator 111 may generate a series of pulses at its output, of which the duty cycles are directly proportional to an instantaneous value of the input signal 112.

The PWM output signal 115 is then amplified by means of the downstream-connected switching amplifier stage 120 (e.g. Class-D), which may comprise a GaN-HEMT (Gallium-Nitride-High-Electron-Mobility-Transistor) or MOS (Metal Oxide Semiconductor) gate driver 121, which in turn drives a pair of high-power switches 122a and 122b. The switches 122a, 122b may comprise HEMTs or FETs or other signal controllable switching devices capable of operating as switches at the frequency of the PWM output signal 115. The switches 122a and 122b may usually be formed by a pair of GaN-HEMT (Gallium-Nitride High-Electron-Mobility-Transistor) MOSFETs (Metal―Oxide― Semiconductor Field-Effect Transistor). For example, the power switches 122a and 122b could be realized by LDMOS (Double-Diffused Metal-Oxide Semiconductor) transistors or by so-called HEMTs (High Electron Mobility Transistors), which may utilize Al-GaN/GaN hetero-structures. Although a voltage-mode Class-D amplifier stage 120 is exemplarily indicated by Fig.1, also a current-mode Class-D amplifier stage could be employed instead. Each of those realizations has a topology comprising two power-transistors 122a, 122b. The pair of power transistors 122a, 122b may be arranged in a totem-pole configuration. Transistors 122a, 122b operate as switches controlled by PWM signals 123a and 123b derived from the PWM output signal 115, respectively. Transistor 122b is connected between an amplifier output 124 and ground. Transistor 122a is connected between the amplifier output 124 and a direct current power supply (not shown). The signals 123a, 123b provided as inputs cause the transistors 122a, 122b be to alternately connect the amplifier output 124 to ground and to the power supply. The transistors 122a, 122b be may be shunted by diodes (not shown) in order to protect the transistors 122a, 122b against damage due to switching transients, respectively.

The Class-D amplifier stage 120 produces an amplified version 125 of the PWM signal 115 at the output 124. An amplified version 135 of the BB or RF input signal 112 may then be reconstructed by means of the downstream-connected bandpass filter 130 before the amplified RF signal 135 is e.g. transmitted by means of an antenna device (not shown).

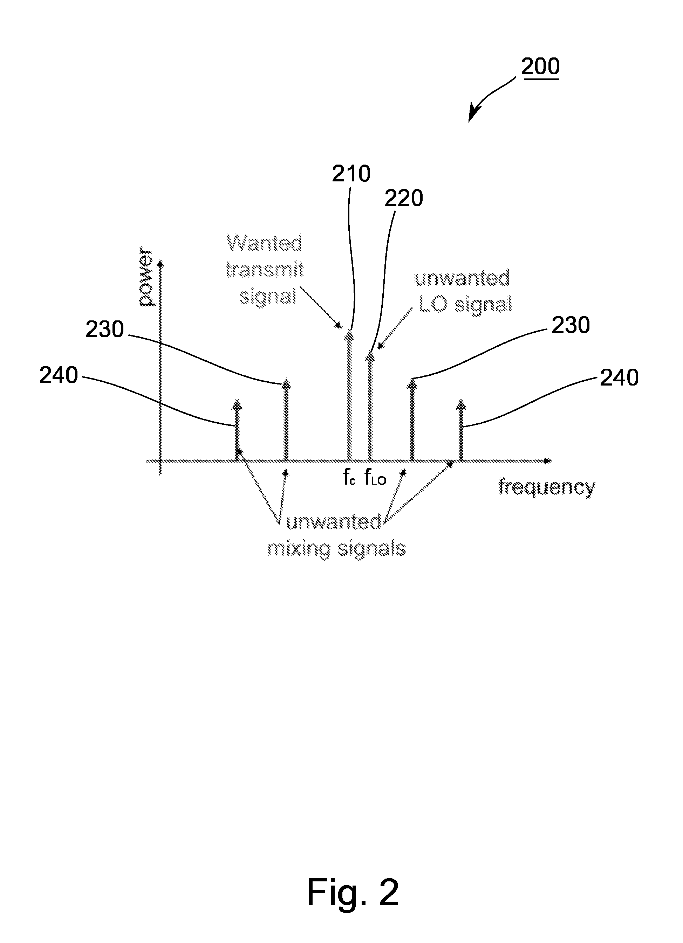

A problem inherent to the conventional Class-S power amplifier design of Fig. 1 becomes apparent when looking at a schematic output power spectrum of the amplified PWM output signal 125. Such an exemplary amplified output signal spectrum 200 for an exemplary sinusoidal input signal 112 at a frequency f_{c} is depicted in Fig. 2.

The output signal power spectrum 200 of the amplified PWM signal 125 comprises a dominant signal component 210 at the fundamental frequency f_{c}. Also, an unwanted or undesired signal component 220 due to the oscillator signal 113 is present at a local oscillator frequency f_{LO}. Due to its non-linearity the pulse-with modulator 110 also possesses frequency mixer properties. Hence, the spectrum 200 of the amplified PWM output signal 125 may additionally comprise further undesired signal components 230 and 240 at frequencies corresponding to mixing products of the input signal 112 (f_{c}) and the PWM oscillator signal 113 (f_{LO}).

Hence, despite an advantageous relatively flat noise characteristic of the amplified PWM signal 125, conventional Class-S amplifier concepts using a PWM have the drawback of having unwanted signal parts 220 at the local oscillator frequency f_{LO} of the PWM as well as mixing frequency components 230, 240 at products of the transmitted frequency f_{c} and the local oscillator frequency f_{LO}. If these undesired local oscillator frequency and mixing components 220, 230 and 240 are not terminated sufficiently by the downstream-connected signal reconstruction filter 130, an overall power efficiency of the Class-S amplifier 100 might severely degrade.

Embodiments may address this situation by providing an improved amplifier circuit, which is taking at least one of the undesired signal components 220, 230 and/or 240 into account.

An idea behind embodiments is to terminate the unwanted frequency parts 220, 230, 240 by frequency termination in order to reduce requirements and effort of the reconstruction filter. The termination could either be done integrated on-chip, externally per transistor 122a, 122b, integrated in the filter 130, or at the combined output 124 of the Class-D stage 120 (e.g. in case of voltage controlled Class-D stage). The frequency termination might not substitute the filter 130 (can be part of the filter) but improves termination, reduces filter effort and contributes to improved overall amplifier efficiency and improved amplifier output power. In order to achieve flexibility with respect to efficiency, also adaptive frequency termination could be used.

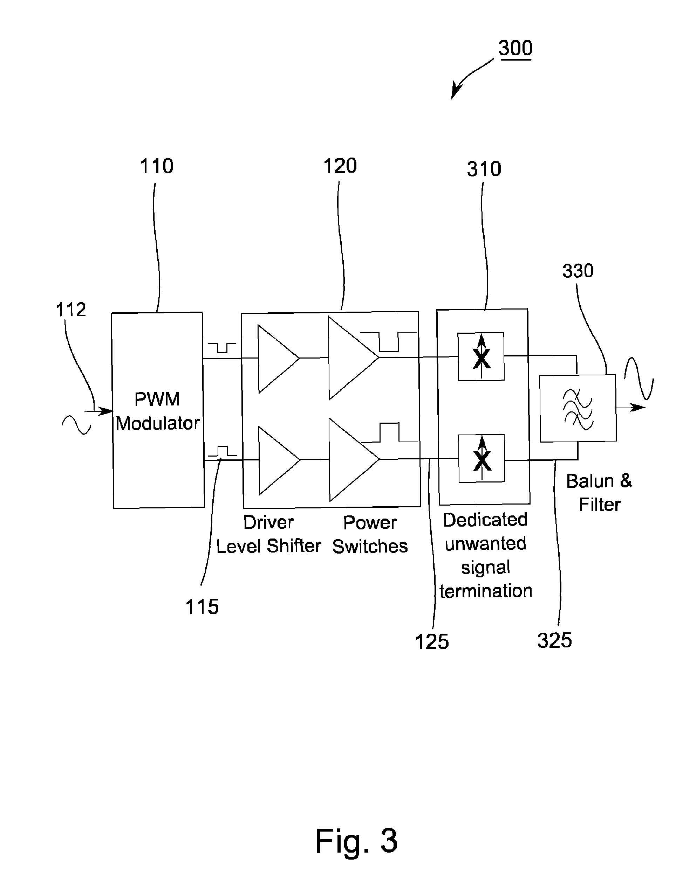

Turning now to Fig. 3, and improved amplifier circuit 300 according to an embodiment will be presented. The same reference numerals as in Fig. 1 indicate similar functional components and/or signals.

The amplifier circuit 300 comprises an input for receiving an electrical input signal 112 having a varying signal envelope which may correspond to a sinusoidal frequency or to a useful frequency spectrum around an input signal center frequency f_{c}. Further, the amplifier circuit 300 comprises a pulse-width modulation circuit 110 which is coupled to the input and which is adapted to generate a pulse-width modulated signal 115 based on a periodic oscillator signal 113 and based on the input signal 112. Thereby, the pulse-width modulation circuit 110 may be a state-of-the-art PWM circuit, which has been exemplary explained before with reference to Fig. 1. Downstream to the PWM circuit 110 the amplifier circuit 300 comprises a switch-mode amplifier stage, which may e.g. be realized by a Class-D amplifier stage 120, for amplifying the generated pulse-width modulated signal 115 to obtain an amplified PWM signal 125 at an output 124 of the switch-mode amplifier stage 120. Embodiments may employ voltage-mode Class-D amplifiers as well as current-mode Class-D amplifiers. Since the mode of operation of the switch-mode amplifier stage 120 has already been explained referring to Fig. 1, further details will be omitted not to unnecessarily obscure the description of embodiments.

In contrast to conventional Class-S switch-mode amplifier concepts, embodiments of the amplifier circuit 300 comprise a termination circuit coupled to the output of the switch-mode amplifier stage 120, wherein the termination circuit 310 is adapted to terminate, in the amplified PWM signal 125, at least one undesired spectral signal component 220, 230 and/or 240 originating from the periodic PWM oscillator signal 113 to obtain a terminated output signal 325 at the output of the terminating circuit 310. Downstream to the termination circuit 310 the amplifier circuit 300 comprises a signal reconstruction filter circuit 330 for reconstructing an amplified version of the input signal 112 based on the terminated PWM output signal 325. Thereby, the signal reconstruction filter circuit 330 may comprise an analogue band-pass filter having a pass-band essentially corresponding to the useful frequency or transmission spectrum of the input signal 112. The signal reconstruction filter circuit 330 may thus e.g. comprise a filter network comprising passive discrete devices such as inductors and/or capacitors.

Due to the advantageous termination circuit 310 the hard termination requirements for RF signal reconstruction filters known from conventional Sigma-Delta modulated Class-S switch-mode amplifier concepts may be significantly relaxed. Due to the use of PWM there is, in contrast to Sigma-Delta modulation, no noise-shaped out-band quantization noise which has to be terminated in a wide and hard-to-handle frequency range. Instead, rather simple reconstruction filter designs may be employed according to embodiments. To ensure high energy efficiency, i.e., to ensure that the amplifier stage 120 does not waste or dissipate power with respect to undesired signal components 220, 230 and/or 240, the termination circuit 310 is connected to the output 124 in embodiments of the amplifier circuit 300. That is, the termination circuit 310 may be adapted to terminate the undesired signal component 220 at the oscillator frequency f_{LO} of the periodic oscillator signal 113. According to further embodiments the termination circuit 310 may also be adapted to terminate an undesired signal component 230 and/or 240 at a frequency corresponding to a mixing product of the oscillator frequency f_{LO} and the input signal center frequency f_{c}. I.e., a required load is transformed at the output 124 of the amplifier stage 120 at the unwanted frequency components 220, 230 and/or 240. According to some embodiments, different components of the termination circuit 310 corresponding to different unwanted frequency components 220, 230 and/or 240 may e.g. be implemented on different (shielded) layers of a multi-layer PCB in order to achieve better resonance and/or isolation properties. I.e., while a termination circuit component corresponding to unwanted frequency component 220 is located on a first layer of a multi-layer PCB, the termination circuit component corresponding to unwanted frequency component 230 is located on a second shielded layer of the multi-layer PCB, and so on.

For this purpose the termination circuit 310 may comprise at least one resonator circuit, which may be adapted to essentially provide a short-circuit termination (towards ground) for the at least one undesired signal component of the amplified PWM signal 125. Such a resonator circuit may comprise either discrete reactive components, such as inductors and/or capacitors or, depending on the oscillator frequency f_{LO} and/or the input signal center frequency f_{c}, transmission line resonators. Transmission line resonators may have better properties for RF frequencies then resonators comprising discrete inductors and/or capacitors. Depending on whether a voltage-mode Class D power amplifier or a current-mode Class-D power amplifier 120 is used, the resonator circuit may e.g. be either placed in series (voltage-mode) between the output 124 of the power amplifier stage 120 and a load or in parallel to a load (current-mode).

According to some embodiments the termination circuit 310 may be located between the output of the switch-mode amplifier-stage 120 and an input of the downstream-connected RF signal reconstruction filter 330. It may be coupled between the output 124 of the amplifier-stage 120 and ground (shunt) and/or between the output 124 and the input of the reconstruction filter 330 (series), dependent on the configuration of the resonator network. However, the termination circuit 310 may as well be integrated in the signal reconstruction filter 330 or it may be integrated on a common multi-layer PCB together with the reconstruction filter 330. Hence, the termination circuit 310 does not necessarily have to be a dedicated circuit separated from other filter or electrical circuits of the amplifier circuit 300. In some embodiments the termination circuit 310 may be integrated on a same Monolithic Microwave Integrated Circuit (MMIC) together with the switch-mode amplifier-stage 120.

In some embodiments more flexibility could be obtained by employing switchable or tunable terminations for different undesired frequency components. Hence, the termination circuit 310 may also be adapted to vary between different frequency terminations corresponding to different undesired signal components, for example, originating from different periodic oscillator signals 113 having different oscillator frequencies f_{LO}, respectively. Such embodiments could, for example, be used when the amplifier circuit 300 shall be used for amplifying different RF signals 112 having different transmission or center frequencies f_{c}. Alternatively or additionally, also different PWM local oscillator signals 113 may be used, leading to different unwanted signal components 220, 230, 240.

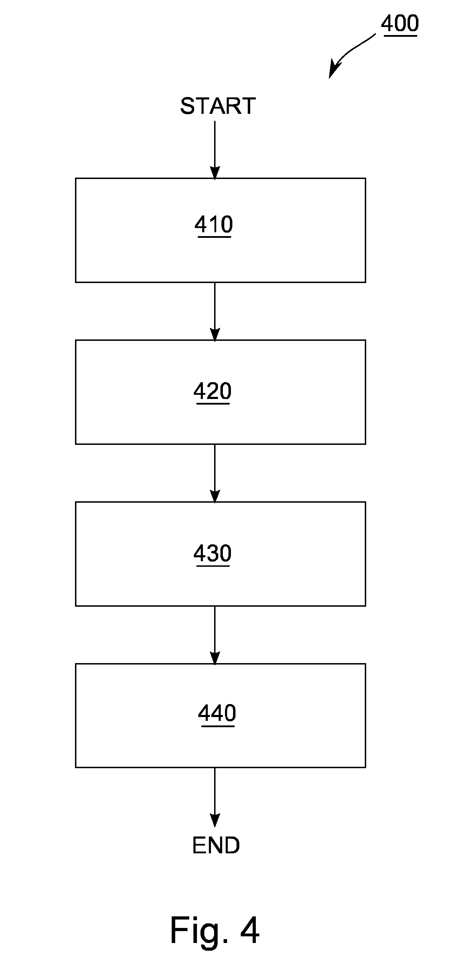

Moreover, embodiments may also provide a method for amplifying a BB or RF input signal 112. Such a method 400 is schematically depicted in Fig. 4.

Method 400 comprises a step 410 of generating a pulse-width modulated signal 115 based on a periodic oscillator signal 113 and the received input signal 112. For this purpose the PWM stage 110 may be used. Further, the generated pulse-width modulated signal 115 is amplified (step 420) with a switch-mode amplifier circuit 120 to obtain an amplified pulse-width modulated signal 125 at an output 124 of the switch-mode amplifier circuit 120. For this purpose a switch-mode amplifier stage 120 may be used, in particular a Class-D amplifier. Advantageously, at least one undesired spectral component 220, 230, 240 originating from the periodic oscillator signal 113 is terminated (step 430) in the amplified pulse-width modulated signal 125 to obtain a terminated signal 325. The termination may be achieved by short-circuiting the respective frequency or signal component using an appropriate resonator circuit. In a step 440 an amplified version of the input signal 112 is reconstructed by means of the band-pass filter 330 based on the terminated signal 325.

To summarize, pulse-width-modulation is used for embodiments of an improved switch-mode power amplifier, e.g. a Class-S amplifier. In case of pulse-width-modulation, a relatively flat low noise level can be achieved with the transmit signal 112 at the wanted transmit frequency f_{c} and unwanted signal parts 220 at the LO frequency of the PWM 110 as well as unwanted signal parts 230, 240 at mixing frequencies of the wanted transmit frequency and the LO frequency. In order to achieve high overall amplifier efficiency, the unwanted signals are terminated suitably by the termination circuit 310, which may also be located within the reconstruction filter, while a low in-band loss is guaranteed by the reconstruction filter. In order to achieve improved load impedance termination of the unwanted signal parts and to reduce filter effort, specific frequency termination of the unwanted frequencies/signals may be achieved with a concept according to Fig. 3. The gained reduced filter out-band termination effort may be used for improved in-band characteristic (e.g. reduced insertion loss).

The termination circuit 310 could be integrated directly on switch-mode or Class-D power amplifier MMICs/transistors, externally of the MMICs, as part of the reconstruction filter, or at the common output 124 of the switch-mode stage 120. Further flexibility could be achieved by positioning of switchable terminations for different frequencies.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks, may be provided through the use of dedicated hardware, as e.g. a processor, as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and nonvolatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. An amplifier circuit (300) comprising:
an input for receiving an input signal (112) having a varying signal envelope corresponding to an input signal frequency spectrum;
a pulse-width modulation circuit (110) which is coupled to the input and which is adapted to generate a pulse-width modulated signal (115) based on a periodic oscillator signal (113) and the received input signal (112);
a switch-mode amplifier circuit (120) for amplifying the generated pulse-width modulated signal (115) to obtain an amplified pulse-width modulated signal (125) at an output of the switch-mode amplifier circuit (120);
a termination circuit (310) coupled to the output of the switch-mode amplifier (120), wherein the termination circuit (310) is adapted to terminate, in the amplified pulse-width modulated signal (125), at least one undesired spectral component (220; 230; 240) originating from the periodic oscillator signal (113) to obtain a terminated signal (325); and
a signal reconstruction filter circuit (330) for reconstructing an amplified version of the input signal (112) based on the terminated signal (325).

2. The amplifier circuit (300) according to claim 1, wherein the switch-mode amplifier circuit (120) comprises a Class-D amplifier circuit.

3. The amplifier circuit (300) according to claim 1, wherein the input signal (112) is a signal with input signal frequency spectrum in a range from baseband frequency to 5 GHz.

4. The amplifier circuit (300) according to claim 1, wherein the signal reconstruction filter (330) is an analog band-pass filter having a pass-band essentially corresponding to the input signal frequency spectrum around a center frequency of the amplified version of the input signal.

5. The amplifier circuit (300) according to claim 1, wherein the termination circuit (310) is adapted to terminate an undesired signal component (220) at an oscillator frequency of the periodic oscillator signal (113).

6. The amplifier circuit (300) according to claim 5, wherein the termination circuit (310) is further adapted to terminate an undesired signal component (230; 240) at a frequency corresponding to a mixing product of the oscillator frequency and the input signal center frequency.

7. The amplifier circuit (300) according to claim 1, wherein the termination circuit (310) comprises at least one resonator circuit which is adapted to provide a short-circuit termination for the at least one undesired signal component (220; 230; 240) of the amplified pulse-width modulated signal (125).

8. The amplifier circuit (300) according to claim 1, wherein the termination circuit (310) is coupled between an output (124) of the switch-mode amplifier circuit (120) and an input of the signal reconstruction filter (330).

9. The amplifier circuit (300) according to claim 1, wherein the termination circuit (310) is integrated with the signal reconstruction filter (330) on a common printed circuit board.

10. The amplifier circuit (300) according to claim 1, wherein the termination circuit (310) comprises discrete reactive resonator components and/or transmission line resonator components.

11. The amplifier circuit (300) according to claim 1, wherein the termination circuit (310) is integrated on a same MMIC as the switch-mode amplifier circuit (120).

12. The amplifier circuit (300) according to claim 1, wherein the termination circuit (310) adapted to vary between different terminations corresponding to different undesired signal components originating from different periodic oscillator signals (113) having different oscillator frequencies, respectively.

13. A mobile station transceiver for a wireless communication system, the mobile station transceiver comprising an amplifier circuit (300) according to claim 1.

14. A base station transceiver for a wireless communication system, the base station transceiver comprising an amplifier circuit (300) according to claim 1.

15. A method (400) for amplifying an input signal (112) having a varying signal envelope corresponding to an input signal frequency spectrum, the method comprising the following steps:
generating (410) a pulse-width modulated signal (115) based on a periodic oscillator signal (113) and the received input signal (112);
amplifying (420) the generated pulse-width modulated signal (115) with switch-mode amplifier circuit (120) to obtain an amplified pulse-width modulated signal (125) at an output of the switch-mode amplifier circuit (120);
terminating (430), in the amplified pulse-width modulated signal (125), at least one undesired spectral component (220; 230; 240) originating from the periodic oscillator signal (113) to obtain a terminated signal (325); and
reconstructing (440) an amplified version of the input signal (112) based on the terminated signal (325).

## Amended claims

### Amended claims in accordance with Rule 137(2) EPC.

**1.** An amplifier circuit (300) for amplifying radio signals in a wireless communication system, comprising:
an input for receiving a radio frequency input signal (112) having a varying signal envelope corresponding to an input signal frequency spectrum;
a pulse-width modulation circuit (110) which is coupled to the input and which is adapted to generate a pulse-width modulated signal (115) based on a periodic oscillator signal (113) and the received radio frequency input signal (112);
a switch-mode amplifier circuit (120) for amplifying the generated pulse-width modulated signal (115) to obtain an amplified pulse-width modulated signal (125) at an output of the switch-mode amplifier circuit (120);
a termination circuit (310) coupled to the output of the switch-mode amplifier (120), wherein the termination circuit (310) is adapted to terminate, in the amplified pulse-width modulated signal (125), at least one undesired spectral component (220; 230; 240) originating from the periodic oscillator signal (113) to obtain a terminated signal (325), wherein the termination circuit (310) comprises at least one resonator circuit which is adapted to provide a short-circuit termination for the at least one undesired signal component (220; 230; 240) of the amplified pulse-width modulated signal (125); and
a signal reconstruction filter circuit (330) for reconstructing an amplified version of the radio frequency input signal (112) based on the terminated signal (325).

**2.** The amplifier circuit (300) according to claim 1, wherein the switch-mode amplifier circuit (120) comprises a Class-D amplifier circuit.

**3.** The amplifier circuit (300) according to claim 1, wherein the wireless communication system is of the group of Global System for Mobile Communications (GSM/EDGE = Enhanced Data rates for GSM Evolution), Wideband Code Division Multiple Access (WCDMA), or Long-Term Evolution (LTE), and wherein the radio frequency input signal (112) is a signal with an input signal frequency spectrum in a range from baseband frequency to 5 GHz.

**4.** The amplifier circuit (300) according to claim 1, wherein the signal reconstruction filter (330) is an analog band-pass filter having a pass-band essentially corresponding to the input signal frequency spectrum around a center frequency of the amplified version of the input signal.

**5.** The amplifier circuit (300) according to claim 1, wherein the termination circuit (310) is adapted to terminate an undesired signal component (220) at an oscillator frequency of the periodic oscillator signal (113).

**6.** The amplifier circuit (300) according to claim 5, wherein the termination circuit (310) is further adapted to terminate an undesired signal component (230; 240) at a frequency corresponding to a mixing product of the oscillator frequency and the input signal center frequency.

**7.** The amplifier circuit (300) according to claim 1, wherein a frequency of the periodic oscillator signal (113) is located within the input signal frequency spectrum.

**8.** The amplifier circuit (300) according to claim 1, wherein the termination circuit (310) is coupled between an output (124) of the switch-mode amplifier circuit (120) and an input of the signal reconstruction filter (330).

**9.** The amplifier circuit (300) according to claim 1, wherein the termination circuit (310) is integrated with the signal reconstruction filter (330) on a common multi-layer printed circuit board, wherein different components of the termination circuit (310) corresponding to different undesired signal components (220, 230, 240) are implemented on different shielded layers of the multi-layer PCB.

**10.** The amplifier circuit (300) according to claim 1, wherein the termination circuit (310) comprises discrete reactive resonator components and/or transmission line resonator components.

**11.** The amplifier circuit (300) according to claim 1, wherein the termination circuit (310) is integrated on a same MMIC as the switch-mode amplifier circuit (120).

**12.** The amplifier circuit (300) according to claim 1, wherein the termination circuit (310) adapted to vary between different terminations corresponding to different undesired signal components originating from different periodic oscillator signals (113) having different oscillator frequencies, respectively.

**13.** A mobile station transceiver for a wireless communication system, the mobile station transceiver comprising an amplifier circuit (300) according to claim 1.

**14.** A base station transceiver for a wireless communication system, the base station transceiver comprising an amplifier circuit (300) according to claim 1.

**15.** A method (400) for amplifying radio signals in a wireless communication system, the method comprising the following steps:
amplifying a radio frequency input signal (112) having a varying signal envelope corresponding to an input signal frequency spectrum;
generating (410) a pulse-width modulated signal (115) based on a periodic oscillator signal (113) and the radio frequency input signal (112);
amplifying (420) the generated pulse-width modulated signal (115) with switch-mode amplifier circuit (120) to obtain an amplified pulse-width modulated signal (125) at an output of the switch-mode amplifier circuit (120);
terminating (430), in the amplified pulse-width modulated signal (125), at least one undesired spectral component (220; 230; 240) originating from the periodic oscillator signal (113) to obtain a terminated signal (325), wherein terminating is performed by providing a short-circuit termination for the at least one undesired signal component (220; 230; 240) of the amplified pulse-width modulated signal (125);
and
reconstructing (440) an amplified version of the radio frequency input signal (112) based on the terminated signal (325).
